# EUROPEAN PATENT APPLICATION

(11) **EP 4 326 008 A1**
(43) Date of publication of application: **21.02.2024**
(21) Application number: 22190947.6
(22) Date of filing: 18.08.2022
(51) Int. Cl.: H05G 1/26

(54) **DEVICE FOR MEASURING AN EMISSION CURRENT OF AN X-RAY TUBE**

(71) Applicant: Koninklijke Philips N.V., 5656 AG Eindhoven (NL)
(72) Inventor: REUSCH, Tobias, Eindhoven (NL); KAHL, Christoph, Eindhoven (NL); HOLMES, Christopher, 5656AG Eindhoven (NL)
(74) Representative: Philips Intellectual Property & Standards

(57) **Abstract**

The invention concerns a device for determining an emission current of an X-ray tube (100), as well as an X-ray tube and an X-ray system comprising such a device. The device includes a sensor (110) configured for determining the emission current (107, 108) of the X-ray tube (100), and a first X-ray tube wire (111) and a second X-ray tube wire (112), which are configured to operate the X-ray tube (100). The sensor (110) is arranged at the first X-ray tube wire (111) and at the second X-ray tube wire (112) at a high voltage potential side of the X-ray tube. The sensor (110) is configured and arranged to measure a resulting magnetic field, which results from superimposed magnetic fields at the sensor (110). The device is configured to determine the emission current (107, 108) of the X-ray tube (100) based on the resulting magnetic field. The invention further concerns a use of a Hall sensor for measuring an emission current of an X-ray tube.

## Description

### FIELD OF THE INVENTION

The invention relates to the field of X-ray tubes, in particular to the field of emission current sensing of an X-ray tube. Moreover, the invention relates to detecting of emission current on a high voltage potential side of an X-ray tube. More specifically, the invention relates to a device for detecting emission current of an X-ray tube, an X-ray tube comprising such a device, an X-ray system comprising such a device, a method of detecting an emission current of an X-ray tube and a use of a Hall sensor for detecting emission current of an X-ray tube.

### BACKGROUND OF THE INVENTION

In practice, the emission current for each X-ray tube depends in different ways on the heating current and the pickup voltage, also for tubes of the same type. For example, after a longer operation of an X-ray tube it might happen that parts of the heating wire surface are evaporated, accordingly the heating wire has become thinner. Then, the same value of heating current may result in a larger emission current than before the evaporation of parts of the heating wire surface. This can cause the current through the X-ray tube to deviate relatively significantly from the desired acquisition current value at the beginning of the acquisition.

In general, the temperature of the filament of an X-ray tube, i.e. the heating current through the filament, is controlled in order to regulate the emission current, i.e. the emission current from the filament to the anode target.

The X-ray tube based emission current measurement is an essential feature for the functionality of the X-ray tube. For instance, filament failures, which might be the main failure mode for some X-ray tubes, due to wear of the tungsten wire can be predicted from the heating current, which is needed to reach a given emission current.

Emission current of an X-ray tube needs a regulation in order to ensure patient safety, for example with respect to the X-ray dose, for avoiding tube overloading, which means avoiding too high temperatures on the anode, for compliance to regulatory aspects, for enabling dose modulation and for enabling the tube temperature supervision.

Hence, a measurement of the emission current may be an improved feature for an X-ray tube monitoring. Therefore, there exists a need for a direct, fast and exact emission current measurement, and there exists a need for a fast and exact regulation of the emission current of an X-ray tube.

### SUMMARY OF THE INVENTION

There exists a need for an improved measurement process of the emission current, which in turn will lead to an improvement of patient safety, for example with respect to the X-ray dose, for monitoring tube overloading, which means avoiding too high temperatures on the anode, for compliance to regulatory aspects, for enabling dose modulation and for improvement of the tube temperature supervision

The inventors of the present invention have observed that a measurement of an emission current on the high voltage potential side of an X-ray tube allows a fast and direct emission current measurement, wherein there is no need to derive the emission current from other X-ray tube measurements, for example from the heating current.

An object of the invention is to provide emission current measurement of an X-ray tube in which the emission current can be measured fast and directly.

The invention is defined by the independent claims, wherein further embodiments are defined by the dependent claims.

According to a first aspect of the invention, a device for determining an emission current of an X-ray tube comprises a sensor configured for determining the emission current of the X-ray tube, and comprises a first X-ray tube wire and a second X-ray tube wire, which are configured to operate the X-ray tube. The sensor is arranged at the first X-ray tube wire and at the second X-ray tube wire, wherein the sensor is arranged at a high voltage potential side of the X-ray tube. Moreover, the sensor is configured and arranged at the first X-ray tube wire and at the second X-ray tube wire in such a manner that a first magnetic field generated by the heating current of the X-ray tube in the first X-ray tube wire and a second magnetic field generated by the emission current of the X-ray tube in the first X-ray tube wire and a third magnetic field generated by the heating current of the X-ray tube in the second X-ray tube wire and a fourth magnetic field generated by the emission current of the X-ray tube in the second X-ray tube wire are superimposed at the sensor. The sensor is configured to measure a resulting magnetic field, which results from the superimposed magnetic fields at the sensor. The device is configured to determine the emission current of the X-ray tube based on the resulting magnetic field.

In the context of the present invention, the term "X-ray tube wire" shall be understood to describe a wire used for operating the X-ray tube, wherein the X-ray tube wire is configured for providing a connection to a power supply for the X-ray tube.

In the context of the present invention, the term "high voltage potential side" shall be understood to describe the voltage side of the X-ray tube, which has a different, e.g. a higher, potential than the earth potential side. Parts for operating the X-ray tube, for example the generator are connected to the earth potential and the power generated by the generator for operating the X-ray tube generates a much higher voltage potential, called the high voltage potential side. The determining of the emission current has to be carried out on high voltage potential (for instance, up to 150 kV are needed for an X-ray tube operation), while the measurement result is needed by and provided to components on earth potential. Accordingly, standard external probes cannot be used. Devices, components and/or elements, which are designed for the earth potential side, are not able to operate on the high voltage potential side. Accordingly, special requirements exist on devices, components and so on for being able to be operated on the high voltage side.

In the context of the present invention, the term "resulting magnetic field" shall be understood to describe a magnetic field, which may be comprised of a superimposing of more than one magnetic field. For instance, the resulting magnetic field may be a main magnetic field, which comprises of or includes the superimposed first, second, third, and fourth magnetic field, or parts thereof. It may comprise a reduced magnetic field of the first and third magnetic field and a non-reduced second and fourth magnetic field.

In this embodiment, the first X-ray tube wire and the second X-ray tube wire are configured to provide a connection between a generator configured for driving the X-ray tube and a cathode of the X-ray tube. The cathode may comprise the filament, hence the wires may provide a connection between the generator and the filament of the X-ray tube. In particular, one wire may be the input wire and the other wire may be the output wire. The sensor is arranged on the high voltage potential side of the X-ray tube at X-ray tube wires providing current from the generator of the X-ray tube to the cathode of the X-ray tube and vice versa, wherein the (X-ray tube) wires connecting the generator and the cathode of the X-ray tube are arranged in such a manner that magnetic fields induced in each wire by a heating current are reduced. In other words, the X-ray tube wires going from the generator into the cathode, the filament, and coming from the cathode, the filament, are to be oriented such that the magnetic fields induced by the heating current are reduced or cancel out. This reduction of the magnetic fields results from the specific arrangement of the sensor at the X-ray tube wires and how the magnetic fields are generated at the X-ray tube wires and how they are detected by the sensor. Depending on the chosen sensor arrangement and /or sensor elements the heating current through the X-ray tube wires may flow in the same direction, or the heating current through the X-ray tube wires may flow in opposing directions. The superimposing of the different magnetic fields results in the effect, that the magnetic fields relating to the heating current will be reduced, or will be cancel out at the sensor, such that only the magnetic field of interest, the magnetic field of the emission current remains measurable for the sensor. As described above, the net contribution by the heating current will effectively be zero while the magnetic field induced by the emission current will lead to a measurable result.

Magnetic field compensation is used in order to differentiate between the heating current and the emission current, both flowing on the high voltage potential side of the X-ray tube. Accordingly, due to the specific arrangement of the sensor at the X-ray tube wire(s) the magnetic fields of the heating current can be reduced, or preferably cancel out by superimposing of the magnetic fields at the sensor. In particular, by superimposing the magnetic fields induced by the heating current, i.e. the input heating current into the X-ray tube and the output heating current from the heating tube, which will be elucidated in the figures herein below. As the heating current into the cathode, the filament, is equal to the heating current from the cathode, the filament, the net magnetic field of the heating current reduce or cancel if the geometry of the arrangement of the device of the present embodiment is chosen accordingly. The remaining magnetic field of the emission currents leads to a measurable signal on the sensor, free of any remaining heating current contributions or at least only some heating currents residuals, which may be filtered out in a later stage. Accordingly, due the reduced heating current magnetic field the dynamic range requirements for the sensor can be reduced, which enables a clean emission current measurement. Hence, the sensor measures the remaining magnetic field of the emission current, which relates to the emission current flowing through the X-ray tube wires. Besides the determining of the emission current, the sensor may also be configured for generating an emission current signal, which signal may comprise the determined value of the emission current and which signal may be provided to further components of the X-ray tube or further components of the embodiment of the invention, which will be described herein below.

The determining of the emission current on the high voltage potential side of the X-ray tube allows a direct and fast determination of this current, such that external probes can me omitted and it is further not necessary to derive the emission current from other measurement values like the heating current. Further, it has the advantage that the high voltage potential side of an X-ray tube may be equipped with such a device, such that a direct and/or internal emission current measurement may be possible.

The emission current may be in a range between 10 mA to 1500 mA, this may be overlaid by a much larger heating current (for example up to 15 A during ramp up). Hence, this would require a large noise free dynamic range of any sensor. When using the device as described herein, the much larger heating current can be reduced such that the sensor is able to measure the remaining emission current. The solution as described hereinabove may be completely autonomous. The limited power requirements may be fulfilled by using some power from the heating current supply. Hence, the device for determining the emission current may be self-contained within the X-ray tube or within the high voltage generator setup, which drives the X-ray tube.

According to an exemplary embodiment of the invention, the sensor is arranged with respect to the first X-ray tube wire and the second X-ray tube wire, such that a heating current flowing through the first X-ray tube wire flows in an opposing current direction than a heating current flowing through the second X-ray tube wire. In other words, the X-ray tube wires going from the generator into the cathode, the filament, and coming from the cathode, the filament, are to be oriented such that the magnetic fields induced by the heating currents are reduced or cancel out. This reduction of the magnetic fields results therefrom that the heating currents flowing in the X-ray tube wires flow in opposite current directions. The superimposing of the different magnetic fields results in the effect, that the magnetic fields relating to the heating current will be reduced, or will be cancel out at the sensor, such that only the magnetic field of interest, the magnetic field of the emission current remains measurable for the sensor. As described above, the net contribution by the heating current will effectively be zero while the magnetic field induced by the emission current will lead to a measurable result.

According to an exemplary embodiment of the invention, the sensor is further configured to generate a voltage signal based on the measured resulting magnetic field, wherein the device is configured to determine the emission current of the X-ray tube based on the generated voltage signal of the sensor. The generated voltage signal comprises a common ratio with the measured magnetic field such that the emission current can be determined with this generated voltage signal. The ratio between the voltage signal, the magnetic field and/or the emission currents may depend on the characteristic of the chosen sensor.

According to an exemplary embodiment of the invention, the resulting magnetic field is a sum of the generated second magnetic field and the generated fourth magnetic field at the sensor. In other words, the resulting magnetic field is the sum of the remaining magnetic fields of the emission currents at the sensor. The resulting magnetic field may depend on the position at which the sensor is arranged. Further, the resulting magnetic field may include external magnetic fields, which are also superimposed at the sensor.

According to an exemplary embodiment of the invention, the sensor is arranged at the first X-ray tube wire and at the second X-ray tube wire inside of the X-ray tube, or the sensor is arranged at the first X-ray tube wire and at the second X-ray tube wire at the high voltage potential side of a generator driving the X-ray tube. Accordingly, the sensor may be arranged on the high voltage potential side of the X-ray tube either inside the X-ray tube or outside the X-ray tube, for example on the generator side, but still on the high-voltage potential side. It may also be possible to arrange for instance two sensors, wherein both are arranged on the high voltage potential side of the X-ray tube. One sensor may be arranged inside the X-ray tube and the other sensor may be arranged outside the X-ray tube as described above. Hence, the device may comprise more than one sensor for measuring and determining the emission current of the X-ray tube. According to this embodiment, differences and changes of the emission current during operation of the X-ray tube can be fast and directly determined at each single sensor and/or at both sensors.

According to an exemplary embodiment of the invention, the device further comprises a substrate, wherein the sensor is arranged on the substrate, wherein the substrate is in particular a printed circuit board (PCB). An advantage of the magnetic field effect cancelation approach is that it allows arranging the sensor and the X-ray tube wires in a very compact size, which can be easily manufactured on the PCB. The X-ray tube wires may be arranged on and/or inside the PCB for being properly aligned with the sensor and for guaranteeing a sufficient superimposing of the magnetic fields to be measured. A sensor-X-ray tube wire arrangement may be called a planar sensor arrangement, as the X-ray tube wires are arranged on different planes relative each other.

According to an exemplary embodiment of the invention, the device further comprises a housing surrounding the sensor and at least partially surrounding the first X-ray tube wire and the second X-ray tube wire, wherein the housing is configured for shielding the sensor from further magnetic fields. Further, the housing may also surround the PCB on which the sensor may be located. Accordingly, the full sensor arrangement, i.e. the device itself is arranged inside a housing and may be shielded from external magnetic fields, which may disturb the sensor and/or may have an influence on the measured magnetic field, or the superimposing of the magnetic fields to be measured.

According to an exemplary embodiment of the invention, at least two X-ray tube wires are arranged below the sensor, wherein the at least two X-ray tube wires are the first X-ray tube wire and the second X-ray tube wire, which are arranged below the sensor.

The X-ray tube wires below the sensor may be arranged above each other providing a stack like arrangement of the X-ray tube wires below the sensor and/or wherein the X-ray tube wires below the sensor are arranged next to each other in the same plane below sensor. In other words, the X-ray tube wires carrying opposing currents might be placed below each other and/or the X-ray tube wires carrying opposing currents might be places next to each other.

According to a further exemplary embodiment, the first X-ray tube wire comprises a plurality of sub-X-ray tube wires and the second X-ray tube wire comprises a plurality of sub-X-ray tube wires. These sub wires may also be arranged below the sensor. Further, the sub wires may also be arrangeable in a stack like arrangement as described above. In particular, the sensor may be configured and arranged at the sub-X-ray tube wires of the first X-ray tube wire and at the sub-X-ray tube wires of the second X-ray tube wire in such a manner that a magnetic field generated by a heating current of the X-ray tube in the sub-X-ray tube wires of the first X-ray tube wire and a magnetic field generated by the emission current of the X-ray tube in the sub-X-ray tube wires of the first X-ray tube wire and a magnetic field generated by a heating current of the X-ray tube in the sub-X-ray tube wires of the second X-ray tube wire and a magnetic field generated by the emission current of the X-ray tube in the sub-X-ray tube wires of the second X-ray tube wire may be superimposed at the sensor.

In other words, the X-ray tube wires may be further sub divided into several individual smaller wires connected in parallel or in series (in order to amplify the magnetic field). For example: two X-ray tube wires carrying input heating current I_in and two X-ray tube wires carrying output heating current I_out. The subdivided X-ray tube wires may be then oriented in various configurations (the two currents I_in on the top layer, two I_out on the bottom layer or I_in left of I_out on the top layer and I out left of I_in on the bottom layer). A practically infinite set of configurations exist. The X-ray tube wires may be distributed across one or several PCB layers. Further, the X-ray tube wires might be surrounded by potentially grounded copper layers on the top / bottom layer of the PCB.

According to an exemplary embodiment of the invention, the device further comprises a magnetic core, wherein the sensor is arranged inside a gap of the magnetic core, wherein the magnetic core is in particular a toroidal magnetic core, wherein the first X-ray tube wire and the second X-ray tube wire extend through the magnetic core or are wound around the magnetic core. In particular, the magnetic core may be a slotted toroidal magnetic core in which the sensor, i.e. a Hall sensor, may be arranged in the gap of the toroidal magnetic core. The X-ray tube wires carrying the heating current and the emission current can either be wound around the magnetic core, which may increase the magnetic field strength, or be fed through the magnetic core. Due to proper cable connection, the heating currents flowing through the wires from the inside and outside direction (I_in and I_out) are flowing in opposing directions and a field effect similar to the planar X-ray tube wire arrangement may occur.

According to an exemplary embodiment of the invention, the sensor comprises at least one Hall sensor for measuring magnetic fields.

The one Hall sensor is sufficient for measuring the magnetic fields generated by the emission and heating current flowing through the X-ray tube wires. On the high voltage potential side of the X-ray tube and/or the generator, no active or passive components in the direct path of the arc-discharge direction are necessary, when using the device according to the embodiment of the invention. The arc-discharge direction is a direction in which X-ray tubes may have arcs, which means very fast discharge events. If such an event may occur, the voltage of about 150 kV is discharged within few µs. These events make it impossible to use simple setups, as shunt resistors, for measuring the emission current, as these would be damaged by respective arcing events. Therefore, when using a Hall sensor, a short current impulse attributed an arc (can be ~1000 A) will lead to a short magnetic field impulse measured by the Hall sensor, but the Hall sensor itself will not be damaged.

According to an exemplary embodiment of the invention, wherein the sensor comprises a first Hall sensor arranged at the first X-ray tube wire, and a second Hall sensor arranged at the second X-ray tube wire. At the first Hall sensor, the first magnetic field and the second magnetic field may superimpose, and wherein at the second Hall sensor the third magnetic field and the fourth magnetic field may superimpose. The first Hall sensor may measure a first resulting magnetic field and the second Hall sensor may measure a second resulting magnetic field, wherein the device may be configured to determine the emission current of the X-ray tube based on the first and second resulting magnetic field. Alternatively to one Hall sensor, it may be possible to use one Hall sensor for each X-ray tube wire, wherein the Hall sensor on the respective X-ray tube wire measures the magnetic fields generated at the X-ray tube wire to which the sensor is attached. Accordingly, not all four magnetic fields have to be measured by one Hall sensor. The device may determine the emission current from both Hall sensors. In particular, the device may determine the emission current from a first voltage signal generated by the first Hall sensor and from a second voltage signal generated by the second Hall sensor. The Hall sensor, or both Hall sensors, may generate an analog output voltage and comprise a sufficiently high bandwidth for being able to measure the magnetic field generated by the emission current and the magnetic field generated by the heating current. By arranging one Hall sensor at each X-ray tube wire, external disturbances, such as external magnetic fields, acting on each respective X-ray tube wire may be reduced or eliminated individually.

According to a further embodiment of the invention, the device may further comprise an amplifier configured to combine the first voltage signal from the first Hall sensor and the second voltage signal from the second Hall sensor. The amplifier may combine both voltage signals to a resulting voltage signal from which the emission current (e.g. its value) can be determined. Depending on the current flow direction of the heating current through the first and second X-ray tube wire the amplifier is configured to combine the first and second voltage by adding the first and second voltage or by subtracting the first and second voltage for determining the emission current.

In particular, if the current flow direction may be different in the first and second X-ray tube wires, the combination of both voltage signals comprises adding both voltage values. On the other hand, if the current flow direction through the first and second X-ray tube wires is identical, the combination of both voltage signals may comprise the subtracting of the analog voltages, wherein the resulting differential voltage at the output of the amplifier is the emission current. In both cases, from the resulting voltage outputted from the amplifier the emission current may be determined by the device. Afterwards further signal cleaning by filtering and conditioning may be added.

The first Hall sensor and the second Hall sensor may be arranged next to each other, wherein they are arranged in a vicinity to each other such that a sensitivity to external fields may be reduced. Contrary, it may also be possible to arrange the first Hall sensor at the first X-ray tube wire spaced apart from the second Hall sensor at the second X-ray tube wire. The used arrangement of the two Hall sensors to each other may depend on the space available at the high voltage potential side of the X-ray tube and/or in the X-ray tube.

The arrangement of the first Hall sensor and the second Hall sensor may be combined with any other embodiment of the invention as described herein. For instance, each of the two Hall sensors may be arranged at a respective X-ray tube wire, which wire may comprise further sub-wires as described hereinabove. Further, when two Hall sensors are used, each of them may be arranged inside a gap of a magnetic (toroidal) core, wherein the first X-ray tube wire and the second X-ray tube wire are extending through different magnetic cores (or are wound around different magnetic cores).

According to an exemplary embodiment of the invention, the device further comprises a communication unit configured for sending a data containing at least the determined emission current to at least one of an X-ray system, a generator of the X-ray tube, and an external analyzing unit. The communication unit may further be configured to receive at least one of a measurement time for measuring the emission current at a specific time, a reference value of the emission current, and a target value of the emission current. The expression at least one of a measurement time for measuring the emission current at a specific time, a reference value of the emission current, and a target value of the emission current means that the communication unit may receive at least one of, or two or all of them. In particular, it means a measurement time for measuring the emission current at a specific time, a reference value of the emission current, and/or a target value of the emission current and that it suffices if e.g. only a reference value of the emission current is present.

The communication unit may further be configured to communicate at least one of a potential gate signal and/or an X-ray tube identification signal, or both to any other external unit or component of an X-ray system, and/or X-ray tube, which means to at least one of them, or also to all of them.

According to an exemplary embodiment, the communication unit is a communication interface, connected to earth potential, wherein the communication with the sensor on the high voltage potential of the X-ray tube may be carried out via optical connections, such as optical fibers, wireless communication, or other electronic components suitable to communicate between different voltage potentials. For example, the communication unit may be using a digital bus, which interfaces to the generator, which could be used to un-lock the full potential power rating of several X-ray tube components, which might be used for avoiding tube overloading.

According to an exemplary embodiment of the invention, the device further comprises at least one filter for filtering remaining heating current of the first X-ray tube wire and/or remaining heating current of the second X-ray tube wire. The filter may be an analog filter and/or a digital filter. Further, the bandwidth of the filter may be about 1 kHz. It may also be possible to use more than one filter. For instance, for each X-ray tube wire a respective filter is used for filtering the magnetic field contributions of the heating current, which after the superimposing at the sensor are not reduced and/or not canceled out. Typically, the heating current is AC, at about 20 kHz, to avoid electron focusing artefacts while the emission current is to first approximation DC subsequent analog or digital filters can be used to limit remaining contributions from the heating current. The filter bandwidth should be about 1 kHz in order to provide enough temporal resolution for a heating current regulation.

According to an exemplary embodiment of the invention, an X-ray tube may comprise a device for measuring emission current on the X-ray tube according to any of the embodiments as described above. The X-ray tube is operated via the first X-ray tube wire and the second X-ray tube wire of the X-ray tube. In particular, the device is arranged at the high voltage potential side of the X-ray tube inside or outside of the X-ray tube.

An advantage may be that the device as described herein above may be used for predictive maintenance for X-ray tubes, such that the usage and vital parameters, which are connected or derivable from the emission current, can be observed. For instance, filament failures (main failure mode for some X-ray tubes) due to wear of the tungsten wire can be predicted from the heating current that is needed to reach a given emission current. Accordingly, the emission current determination, may allow a conclusion about the status of the filament.

According to an exemplary embodiment of the invention, an X-ray system comprises an X-ray tube, a generator configured for driving the X-ray tube, and a device for measuring emission current of the X-ray tube according to any of the embodiments as described above. The X-ray tube is operated by the generator via the first X-ray tube wire and the second X-ray tube wire of the X-ray tube, wherein the device may be configured to communicate with the X-ray system using the communication unit of the device.

According to a second aspect of the invention, a method for measuring an emission current of an X-ray tube is described. The method comprises the following steps: operating the X-ray tube using a first X-ray tube wire and a second X-ray tube wire, arranging a sensor at the first X-ray tube wire and at the second X-ray tube wire, in particular such that a heating current flowing through the first X-ray tube wire and a heating current flowing through the second X-ray tube wire are detectable by the sensor. The step of arranging of the sensor comprises a positioning of the sensor at the high voltage potential side of the X-ray tube. Further, the method comprises the step of superimposing, due to the configuration and arrangement of the sensor, a first magnetic field generated by the heating current of the X-ray tube in the first X-ray tube wire and a second magnetic field generated by the emission current of the X-ray tube in the first X-ray tube wire and a third magnetic field generated by the heating current of the X-ray tube in the second X-ray tube wire and a fourth magnetic field generated by the emission current of the X-ray tube in the second X-ray tube wire. Furthermore, the method comprises the step of measuring by the sensor a resulting magnetic field of the superimposed magnetic fields at the sensor, and determining the emission current of the X-ray tube based on the resulting magnetic field of the superimposed magnetic fields at the sensor.

The step of arranging may further comprise arranging a sensor at the first X-ray tube wire and at the second X-ray tube wire, such that a heating current flowing through the first X-ray tube wire flows in an opposing current direction than a heating current flowing through the second X-ray tube wire.

If the sensor may comprise at least two Hall sensors, the first and second Hall sensor as described with the embodiments hereinabove, the step of arranging the sensor may further comprise arranging the first Hall sensor at the first X-ray tube wire and arranging the second Hall sensor at the second X-ray tube wire. The determining step of the emission current may further comprise determining of a voltage resulting from the measured resulting magnetic field. In particular, when using two Hall sensors, the determining step may further comprise determining a first voltage at the first Hall sensor and determining a second voltage at the second Hall sensor. Afterwards, combining the first and second voltage value, for instance via an amplifier as described with the embodiments hereinabove, wherein the resulting voltage value is used to determine the emission current of the X-ray tube.

According to a third aspect of the invention, a use of a Hall sensor is described for measuring an emission current of an X-ray tube by superimposing a magnetic field generated by a heating current of the X-ray tube in a first X-ray tube wire and a magnetic field generated by an emission current of the X-ray tube in the first X-ray tube wire and a magnetic field generated by a heating current of the X-ray tube in a second X-ray tube wire and a magnetic field generated by the emission current of the X-ray tube in the second X-ray tube wire, and by determining the emission current of the X-ray tube based on a resulting magnetic field, which results from the superimposed magnetic fields at the Hall sensor. When using a Hall sensor, the device may be operated at the high voltage potential side of the X-ray tube autonomously. Further, the Hall sensor may not be damaged by possible arcing events of the X-ray tube, as described above. Depending on the position of the Hall sensor at the X-ray tube wire or the X-ray tube wires, a magnetic value of the first, second, third, and fourth magnetic field may differ from each other, wherein it may be possible that not all magnetic fields are superimposed at the sensor. Hence, the magnetic value might be almost zero from some of the first, second, third, and/or fourth magnetic field.

When using at least two Hall sensors, not all four magnetic fields may be equally superimposed at each Hall sensor. For instance, a first Hall sensor is used at the first X-ray tube wire, wherein the first and second magnetic field are superimposed at the first Hall sensor. Contrary, a second Hall sensor may be used at the second X-ray tube wire, wherein the third and fourth magnetic field are superimposed at the second Hall sensor. Accordingly, the first Hall sensor may measure a first resulting magnetic field and the second Hall sensor may measure a second resulting magnetic field.

According to a fourth aspect of the invention, a computer program element for measuring an emission current of an X-ray tube is described. The computer program element, when being executed by a processor of a device for measuring emission current of an X-ray tube, is adapted to cause the device to measure the emission current of the X-ray tube by at least one sensor, receive data from the at least sensor and analyze the received data, by a data processing unit, thereby evaluating based on the analyzed data whether the measured emission current is at least one of a target emission current, a threshold emission current, control the at least one sensor and/or X-ray tube based on the determined emission current.

A threshold emission current may be a threshold, which should not be exceeded. This threshold may be used for a critical component temperature of the X-ray tube, or single components of the X-ray tube, as the cathode, filament or the like. The computer program element may control at least one sensor, wherein this sensor might be controlled in such a manner that the measuring times could be set by the computer program element, or measuring intervals or the filtering of the measured value may be controlled.

The computer program element may also be adapted to cause the device to measure the emission current of the X-ray tube by a sensor comprising at least two Hall sensors.

It has to be noted that embodiments of the invention have been described with reference to different subject matters. In particular, some embodiments have been described with reference to apparatus type claims whereas other embodiments have been described with reference to method type claims. However, a person skilled in the art will gather from the above and the following description that, unless other notified, in addition to any combination of features belonging to one type of subject matter also any combination between features relating to different subject matters, in particular between features of the apparatus type claims and features of the method type claims, and features of the use type claims is considered as to be disclosed with this application.

### BRIEF DESCRIPTION OF THE DRAWINGS

The aspects defined above and further aspects of the present invention are apparent from the examples of embodiment to be described hereinafter and are explained with reference to the examples of embodiment. The invention will be described in more detail hereinafter with reference to examples of embodiments but to which the invention is not limited.
Fig. 1 illustrates an arrangement of a device for detecting emission current in an X-ray tube according to an embodiment of the invention.
Fig. 2 illustrates an arrangement of a device for detecting emission current in an X-ray tube according to an embodiment of the invention.
Fig. 3 illustrates an example of a distribution of magnetic fields in a device for detecting emission current in an X-ray tube according to an embodiment of the invention.
Fig. 4 illustrates an arrangement of a device for detecting emission current in an X-ray tube according to an embodiment of the invention.
Fig. 5 illustrates an arrangement of a device for detecting emission current in an X-ray tube according to an embodiment of the invention
Fig. 6 illustrates an X-ray system comprising a device for detecting emission current in an X-ray tube according to an embodiment of the invention.
Fig. 7 illustrates an arrangement of a device comprising two Hall sensors according to an embodiment of the invention.

### DETAILED DESCRIPTION OF EMBODIMENTS

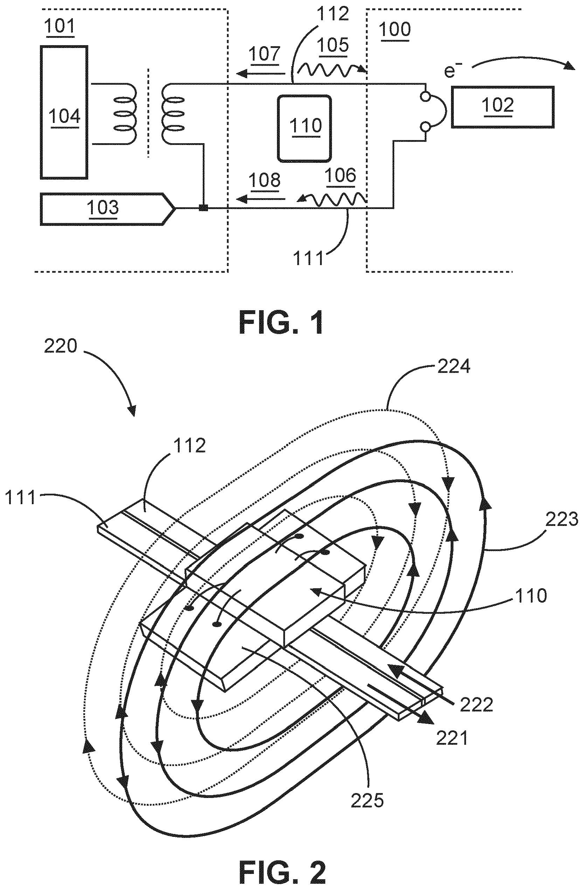

Fig. 1 illustrates an arrangement comprising a device for determining an emission current 107, 108 of an X-ray tube 100. Fig. 1 schematically shows the arrangement of an X-ray tube 100 and a generator 101, wherein X-ray tube wires 111 and 112 provide a connection between the X-ray tube 100 and the generator 101. In particular, the X-ray tube 100 is operated by a filament drive 104, which is connected via the X-ray tube wires 111, 112 to the cathode, and the filament 102. The device comprises a sensor 110 configured for determining the emission current 107, 108 of the X-ray tube 100, a first X-ray tube wire 111 and a second X-ray tube wire 112, which are configured to operate the X-ray tube 100. The sensor 110 is arranged at the first X-ray tube wire 111 and at the second X-ray tube wire 112, or the sensor 110 is located near the X-ray tube wires 111, 112. As can be seen in Fig. 1, the sensor 110 is arranged at a high voltage potential side of the X-ray tube 100, wherein the high voltage potential side in Fig. 1 is the right side of the generator 101, wherein the high voltage 103 is connected to the X-ray tube wires 111, 112. On the left side of the generator 101, the generator 101 is connected to the earth potential. The sensor 110 is arranged with respect to the first X-ray tube wire 111 and the second X-ray tube wire 112, in particular such that a heating current 106 flowing through the first X-ray tube wire 111 flows in an opposing current direction than a heating current 105 flowing through the second X-ray tube wire 112. In Fig. 1, the opposite current directions are illustrated with the arrows pointing to different sides (see 106 and 105). Further, the sensor 110 is configured and arranged at the first X-ray tube wire 111 and at the second X-ray tube wire 112 in such a manner that a first magnetic field 223 generated by the heating current 106 of the X-ray tube 100 in the first X-ray tube wire 111 and a second magnetic field generated by the emission current 108 of the X-ray tube 100 in the first X-ray tube wire 111 and a third magnetic field 224 generated by the heating current 105 of the X-ray tube 100 in the second X-ray tube wire 112 and a fourth magnetic field generated by the emission current 107 of the X-ray tube 100 in the second X-ray tube wire 112 are superimposed at the sensor 110. The sensor 110 is configured to measure a resulting magnetic field, which results from the superimposed magnetic fields at the sensor 110. Moreover, the device is configured to determine the emission current 107, 108 of the X-ray tube 100 based on the resulting magnetic field. The sensor 110 is further configured to generate a voltage signal based on the measured resulting magnetic field, wherein the device is configured to determine the emission current 107, 108 of the X-ray tube 100 based on the generated voltage signal of the sensor 110.

The arrangement of Fig. 1 may further comprise a communication unit, which is not illustrated in Fig. 1. The communication unit may be configured for sending a data containing at least the determined emission current to at least one of an X-ray system, the generator 101, the X-ray tube 100, and/or an external analyzing unit. The communication unit may be connected to the sensor 110 via an optical fiber, a digital bus and/or a wireless connection.

Fig. 2 illustrates a detail of the arrangement device 220, the sensor 110 above the X-ray tube wires 111, 112 and the generated magnetic fields 223, 224. The sensor 110 is arranged above the X-ray tube wires 111 and 112, wherein in the embodiment the wires 111, 112 are arranged next to each other in the same plane. Due to the heating current 221 and 222 flowing through the wires 111, 112 magnetic fields 223 and 224 are generated. In particular, in the first X-ray tube wire 111 the heating current 221 generates the magnetic field 223 and the heating current 222 flowing through the second X-ray tube wire 112 in the opposite direction than the heating current 221 generates the magnetic field 224. The magnetic fields 223 and 224 and the not illustrated magnetic fields of the emission current are superimposed at the sensor 110, wherein the magnetic fields 223 and 224 are reduced or canceled out. The first magnetic field is the illustrated magnetic field 223 and the third magnetic field is the illustrated magnetic field 224. The resulting magnetic field is a sum of the generated second magnetic field and the generated fourth magnetic field from which sum the device is configured to determine the emission current of the X-ray tube. As can be seen in Fig. 2 the sensor is arranged at a substrate 225, wherein the substrate 225 is in particular a printed circuit board. The wires 111 and 112 are arranged at the substrate 225, the wires 111, 112 may also be arranged inside the substrate 225. In Fig. 2 at least two X-ray tube wires 111, 112 are arranged below the sensor 110 (and on the substrate 225). The sensor 110 may be a Hall sensor for measuring the magnetic fields.

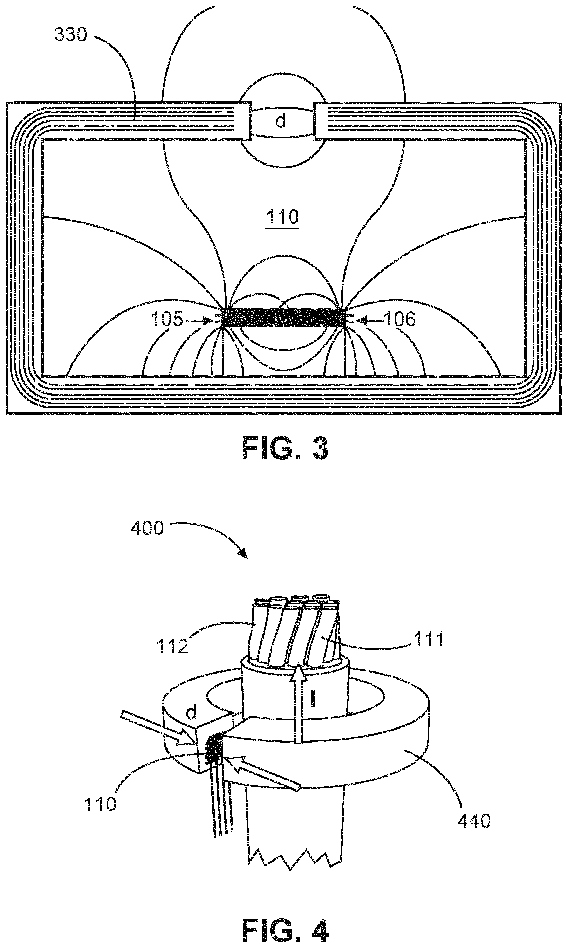

Fig. 3 illustrates a housing 330 surrounding the sensor 110 and at least partially surrounding the first X-ray tube wire 111 and the second X-ray tube wire 112, wherein the housing 330 is configured for shielding the sensor 110 from further magnetic fields. The housing 330 in Fig. 3 comprises a rectangular shape, wherein also other shapes of the housing 330 are possible. The shape of the housing 330 may be adapted to the geometry of the X-ray tube to which the device may be attached. The housing 330 serves for shielding the device from external magnetic fields. Inside the housing 330 the sensor and at least partially the X-ray tube wires 111, 112 may be arranged.

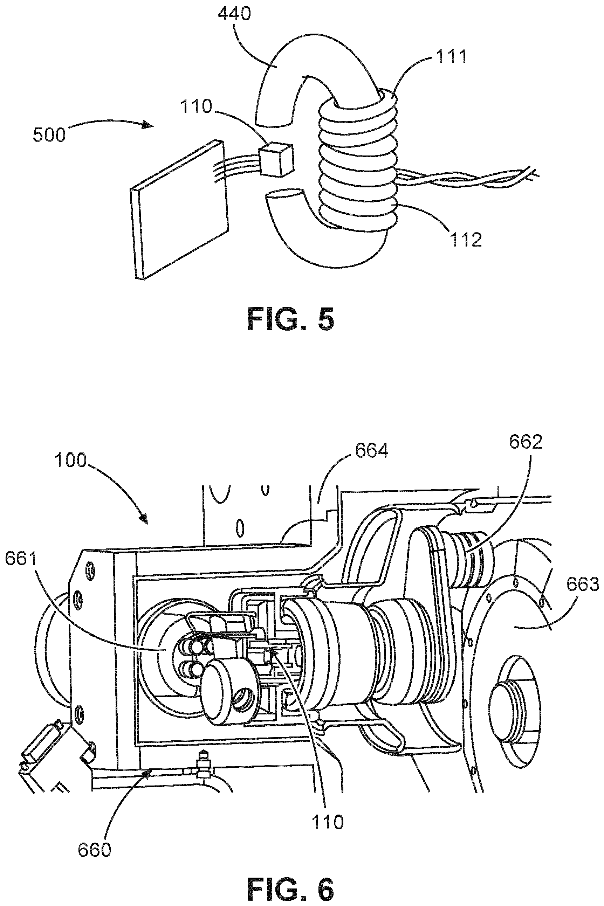

Fig. 4 and Fig. 5 illustrate a further embodiment of the invention, wherein the device 400, 500 comprises a magnetic core 440. The sensor 110 is arranged inside a gap d of the magnetic core 440, wherein the magnetic core 440 is in particular a toroidal magnetic core. The first X-ray tube wire 111 and the second X-ray tube 112 wire are extending through the magnetic core 440, as illustrated in Fig. 4, or are wound around the magnetic core, as illustrated in Fig. 5. The heating current flowing through the X-ray tube wires 111 and 112 are connected in such a manner that the heating current through the first X-ray tube wire 111 flows through the wire in an opposing direction than the heating current flowing through the second X-ray tube wire 112. The sensor 110 in the gap d of the magnetic core measures the first, second, third and fourth magnetic field, wherein due to the opposing flow directions of the heating currents, the heating currents are reduced and/or cancelled out, such that the magnetic field contribution of the heating current is almost zero. Accordingly, the sensor 110 measures the remaining magnetic fields (second and fourth) of the emission currents in the X-ray tube wires 111, 112.

Fig. 6 illustrates an X-ray system 660 comprising an X-ray tube 100 and a generator at which a high voltage connector 661 is provided for connecting the X-ray tube wires 111, 112 with the cathode 662 of the X-ray tube 100. The cathode, 662 can emit electrons and an anode 663 can collect the electrons, which during the operation of the X-ray tube generates a respective emission current. The X-ray tube 100 components are arranged inside a housing 664 and according to this embodiment the device, including the sensor 110 is also arranged inside the housing of the X-ray tube. Hence, the device is arranged inside the X-ray tube 100 on the high voltage potential side. In particular, the sensor 110 is arranged at the first X-ray tube wire and at the second X-ray tube wire inside of the X-ray tube 100. On the other hand, the sensor may be arranged at the first X-ray tube wire and at the second X-ray tube wire at the high voltage potential side of a generator driving the X-ray tube 100. In Fig. 6, the arrangement of the sensor 110 inside the X-ray tube is displayed only schematically, as the specific arrangement depends on the respective X-ray tube at which the device should be installed.

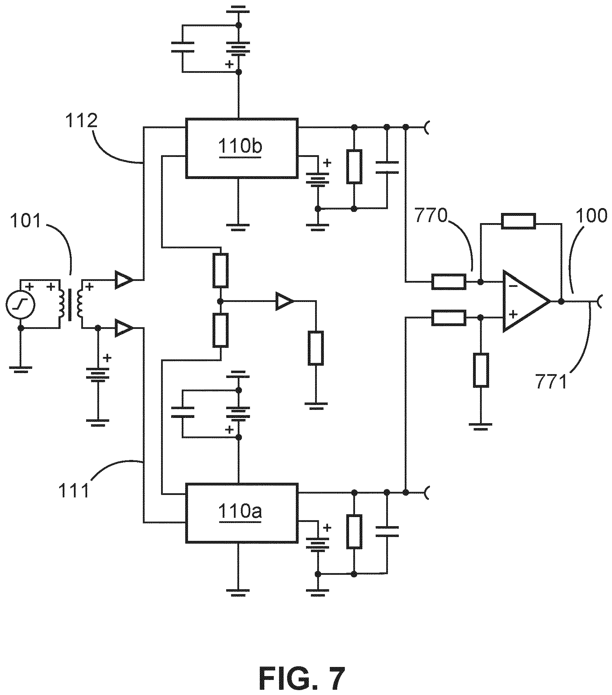

Fig. 7 illustrates a device wherein at least two Hall sensors 110a and 110b are used for determining the emission current of an X-ray tube 100. The arrangement is illustrated only schematically. On the left side, the generator 101 is arranged and from the generator 101 the X-ray tube wires 111 and 112 extend to the right side, on which side the wires 111, 112 are connected to the X-ray tube 100. At the first X-ray tube wire 111, the first Hall sensor 110a is arranged and at the second X-ray tube wire 112, the second Hall sensor 110b is arranged. The Hall sensors 110a, 110b may be arranged close to each other, such that external magnetic fields may not have an influence. Alternatively, the Hall sensors 110a, 110b may be arranged spaced apart from each other. For instance, the first Hall sensor 110a may be arranged on the high voltage potential side near the generator 101, or at the generator 101 and the second Hall sensor 110b may be arranged inside the X-ray tube (each on the respective X-ray tube wire), or vice versa. The sensors 110a, 110b may be arranged in such a manner that the heating current flowing through the first X-ray tube wire 111 flows in an opposing current direction than the heating current flowing through the second X-ray tube wire 112. On the other hand, the sensor 110a, 110b may be arranged such that the heating currents through the first and second X-ray tube wires comprise the same current direction. Depending on the chosen arrangement of the sensors 110a, 110b at the wires 111, 112, the amplifier 770 has to perform a respective combination of the measured signals. For instance, a subtraction or a summation of the first voltage signal and the second voltage signal. The resulting signal (or in general the resulting value) received at the output from the amplifier is the emission current signal 771 or the resulting voltage signal at the output of the amplifier 770 is used to determine the emission current.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps and the indefinite article "a" or "an" does not exclude a plurality. A single processor or other unit may fulfill the functions of several items recited in the claims. Measures recited in mutually different dependent claims may be advantageously combined. Any reference signs in the claims should not be construed as limiting the scope.

### LIST OF REFERENCE SIGNS:

- 100: X-ray tube
- 101: generator
- 102: filament
- 103: high voltage
- 104: filament drive
- 105, 221: input heating current
- 106, 222: output heating current
- 107: emission current
- 108: emission current
- 110: sensor
- 110a, 110b: Hall sensor
- 111: first X-ray tube wire
- 112: second X-ray tube wire
- 200, 400, 500: device
- 223: magnetic field (output)
- 224: magnetic field (input)
- 225: substrate
- 330: housing
- 440: magnetic core
- 660: X-ray system
- 661: high voltage connector
- 662: cathode
- 663: anode
- 664: housing
- 770: amplifier
- 771: emission current signal

## Claims

1. A device for determining an emission current of an X-ray tube (100), the device comprising:
a sensor (110) configured for determining the emission current (107, 108) of the X-ray tube (100),
a first X-ray tube wire (111) and a second X-ray tube wire (112), which are configured to operate the X-ray tube (100),
wherein the sensor (110) is arranged at the first X-ray tube wire and at the second X-ray tube wire,
wherein the sensor (110) is arranged at a high voltage potential side of the X-ray tube,
wherein the sensor (110) is configured and arranged at the first X-ray tube wire and at the second X-ray tube wire in such a manner that a first magnetic field generated by the heating current of the X-ray tube in the first X-ray tube wire and a second magnetic field generated by the emission current of the X-ray tube in the first X-ray tube wire and a third magnetic field generated by the heating current of the X-ray tube in the second X-ray tube wire and a fourth magnetic field generated by the emission current of the X-ray tube in the second X-ray tube wire are superimposed at the sensor,
wherein the sensor (110) is configured to measure a resulting magnetic field, which results from the superimposed magnetic fields at the sensor,
wherein the device is configured to determine the emission current of the X-ray tube based on the resulting magnetic field.

2. A device according to claim 1,
wherein the sensor (110) is arranged with respect to the first X-ray tube wire and the second X-ray tube wire, such that a heating current flowing through the first X-ray tube wire flows in an opposing current direction than a heating current flowing through the second X-ray tube wire.

3. A device according to claim 1 or 2,
wherein the sensor (110) is further configured to generate a voltage signal based on the measured resulting magnetic field,
wherein the device is configured to determine the emission current of the X-ray tube based on the generated voltage signal of the sensor (110).

4. A device according to any of the preceding claims,
wherein the sensor (110) is arranged at the first X-ray tube wire and at the second X-ray tube wire inside of the X-ray tube, or
wherein the sensor (110) is arranged at the first X-ray tube wire and at the second X-ray tube wire at the high voltage potential side of a generator driving the X-ray tube.

5. A device according to any of the preceding claims, further comprising
a housing surrounding the sensor (110) and at least partially surrounding the first X-ray tube wire and the second X-ray tube wire,
wherein the housing is configured for shielding the sensor (110) from further magnetic fields.

6. A device according to any of the preceding claims,
wherein at least two X-ray tube wires are arranged below the sensor (110), wherein the at least two X-ray tube wires are the first X-ray tube wire and the second X-ray tube wire, which are arranged below the sensor.

7. A device according to any of the preceding claims 1 to 5, further comprising
a magnetic core,
wherein the sensor (110) is arranged inside a gap of the magnetic core, wherein the magnetic core is in particular a toroidal magnetic core,
wherein the first X-ray tube wire and/or the second X-ray tube wire are extending through the magnetic core or are wound around the magnetic core.

8. A device according to any of the preceding claims,
wherein the sensor (110) comprises at least one Hall sensor for measuring magnetic fields.

9. A device according to any of the preceding claims 1 to 7,
wherein the sensor (110) comprises a first Hall sensor arranged at the first X-ray tube wire, and
a second Hall sensor arranged at the second X-ray tube wire,
wherein at the first Hall sensor the first magnetic field and the second magnetic field superimpose,
wherein at the second Hall sensor the third magnetic field and the fourth magnetic field superimpose,
wherein the first Hall sensor measures a first resulting magnetic field and the second Hall sensor measures a second resulting magnetic field,
wherein the device is configured to determine the emission current of the X-ray tube based on the first and second resulting magnetic field.

10. A device according to any of the preceding claims, further comprising
a communication unit configured for sending a data containing at least the determined emission current to at least one of an X-ray system, a generator of the X-ray tube, and an external analyzing unit.
wherein the communication unit is further configured to receive at least one of a measurement time for measuring the emission current at a specific time, a reference value of the emission current, and a target value of the emission current.

11. A device according to any of the preceding claims, further comprising
at least one filter for filtering remaining heating current of the first X-ray tube wire and/or remaining heating current of the second X-ray tube wire,
wherein the filter is an analog filter and/or a digital filter,
wherein the bandwidth of the filter is about 1 kHz.

12. An X-ray tube, comprising
a device for measuring emission current on the X-ray tube according to any of the claims 1 to 11,
wherein the X-ray tube is operated via the first X-ray tube wire and the second X-ray tube wire of the X-ray tube.

13. An X-ray system comprising
an X-ray tube,
a generator configured for driving the X-ray tube,
a device for measuring emission current of the X-ray tube according to any of the claims 1 to 11,
wherein the X-ray tube is operated by the generator via the first X-ray tube wire and the second X-ray tube wire of the X-ray tube
wherein the device is configured to communicate with the X-ray system using a communication unit of the device.

14. A method for measuring an emission current of an X-ray tube, the method comprising
operating the X-ray tube using a first X-ray tube wire and a second X-ray tube wire,
arranging a sensor at the first X-ray tube wire and at the second X-ray tube wire,
wherein the step of arranging of the sensor comprises a positioning of the sensor at the high voltage potential side of the X-ray tube,
superimposing, due to the configuration and arrangement of the sensor, a first magnetic field generated by the heating current of the X-ray tube in the first X-ray tube wire and a second magnetic field generated by the emission current of the X-ray tube in the first X-ray tube wire and a third magnetic field generated by the heating current of the X-ray tube in the second X-ray tube wire and a fourth magnetic field generated by the emission current of the X-ray tube in the second X-ray tube wire,
measuring by the sensor a resulting magnetic field of the superimposed magnetic fields at the sensor,
determining the emission current of the X-ray tube based on the resulting magnetic field of the superimposed magnetic fields at the sensor.

15. Use of a Hall sensor for measuring an emission current of an X-ray tube by superimposing a magnetic field generated by a heating current of the X-ray tube in a first X-ray tube wire and a magnetic field generated by an emission current of the X-ray tube in the first X-ray tube wire and a magnetic field generated by a heating current of the X-ray tube in a second X-ray tube wire and a magnetic field generated by the emission current of the X-ray tube in the second X-ray tube wire, and by determining the emission current of the X-ray tube based on a resulting magnetic field, which results from the superimposed magnetic fields at the Hall sensor.
